(19) Europäisches Patentamt
European Patent Office
Office européen des brevets

(11) EP 2 284 222 A2

(12) **EUROPEAN PATENT APPLICATION**

(43) Date of publication:
**16.02.2011 Bulletin 2011/07**

(51) Int Cl.:
***C08L 65/00*** *(2006.01)*

(21) Application number: **10171979.7**

(22) Date of filing: **05.08.2010**

(84) Designated Contracting States:
**AL AT BE BG CH CY CZ DE DK EE ES FI FR GB GR HR HU IE IS IT LI LT LU LV MC MK MT NL NO PL PT RO SE SI SK SM TR**
Designated Extension States:
**BA ME RS**

(30) Priority: **10.08.2009 US 538501**

(71) Applicant: **Xerox Corporation**
**Rochester,**
**New York 14644 (US)**

(72) Inventors:
- **Wu, Yiliang**
  **Oakville Ontario L6H 0C6 (CA)**
- **Liu, Ping**
  **Mississauga Ontario L5M 3H2 (CA)**
- **Hu, Nan-Xing**
  **Oakville Ontario L6H 7V3 (CA)**

(74) Representative: **De Anna, Pier Luigi**
**Notarbartolo & Gervasi GmbH**
**Bavariaring 21**
**80336 München (DE)**

(54) **Semiconductor composition**

(57) A semiconducting liquid composition including a semiconducting material comprising a compound of the formula disclosed herein, a liquid vehicle, a solubility promoter that enhances solubility of the semiconducting polymer; and an optional crystallization inhibitor.

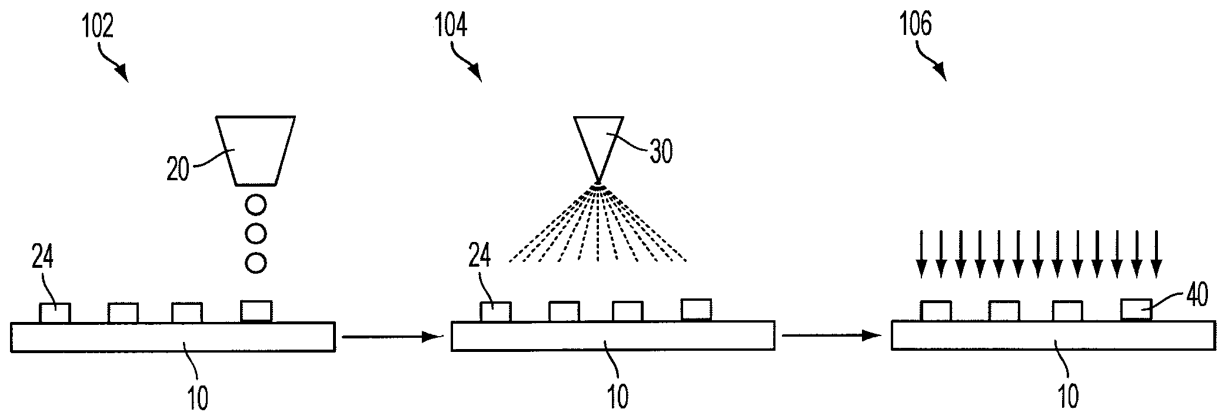


FIG. 1B

EP 2 284 222 A2

## Description

## BACKGROUND

The present invention relates, in various embodiments, to formulations and processes suitable for use in electronic devices, such as thin film transistors ("TFT"s). The present disclosure also relates to components or layers produced using such compositions and processes, as well as electronic devices containing such materials.

Thin film transistors (TFTs) are fundamental components in modem-age electronics, including, for example, sensors, image scanners, and electronic display devices. TFTs are generally composed of a supporting substrate, three electrically conductive electrodes (gate, source and drain electrodes), a channel semiconducting layer, and an electrically insulating gate dielectric layer separating the gate electrode from the semiconducting layer. It is generally desired to make TFTs which have not only much lower manufacturing costs, but also appealing mechanical properties such as being physically compact, lightweight, and flexible. One approach is through organic thin-film transistors ("OTFT"s), wherein one or more components of the TFT includes organic compounds. In particular, some components can be deposited and patterned using inexpensive, well-understood printing technology.

Inkjet printing, such as drop on demand printing, is believed to be a very promising method to fabricate OTFTs. As to the fabrication process, inkjet printing the organic semiconductor is a critical step. Accordingly, a jettable semiconductor ink is required.

One general approach to form a liquid composition, such as an ink composition to be used with deposition methods including spin coating, printing, and the like, is to dissolve a semiconducting material in a proper solvent to form a solution or to form a dispersion. However, semiconducting materials, particularly p-type semiconducting materials, are not readily soluble and/or do not readily remain in solution. For example, semiconducting polymers have been known to precipitate out immediately when the liquid composition is cooled to room temperature. Therefore, known liquid (ink) compositions may not meet all requirements for coating or inkjet printing of semiconducting materials. For example, known ink compositions may not possess desired high mobility in combination with stability at room temperature and suitable processing characteristics. Increasing the carbon side chain length on the semiconducting material can increase solution stability at room temperature. However, increased carbon chain length may result in reduced mobility. Coating semiconductor thin film at elevated temperature can present problems due to the low viscosity of the coating solution at elevated temperature (for example, temperatures above room temperature, such as from about 30 °C to about 50 °C). It is desired to have, for example, a uniform thin film of, for example, from about 30 to about 50 nanometers for transistor devices. This thickness is preferred to obtain high mobility in combination with low off current.

It would be desirable to provide a semiconducting ink formulation which has stability at room temperature along with suitable processing characteristics such as suitability for spin coating and inkjet printing applications.

## SUMMARY

Disclosed is a liquid composition comprising a semiconducting material comprising a compound of the formula

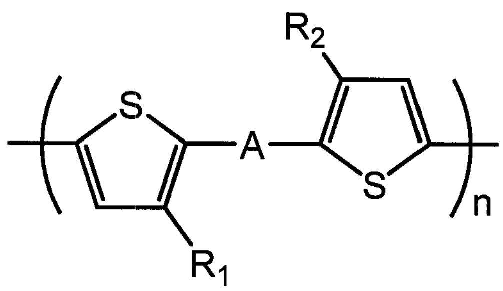

(I)

wherein A is a divalent linkage; $R_1$ and $R_2$ are each independently selected from hydrogen, alkyl, substituted alkyl, alkoxy, substituted alkoxy, a suitable hetero-containing group, a halogen, perhaloalkyl, alkoxyalkyl, siloxyl-substituted alkyl, polyether; and n is an integer from about 2 to about 5,000; a liquid vehicle; a solubility promoter that enhances solubility of the semiconducting material; and an optional crystallization inhibitor.

Further disclosed is a method of forming a semiconducting layer of a thin film transistor comprising a) providing a liquid composition comprising a semiconducting material as described herein; b) applying the liquid composition over a substrate of the transistor; and c) drying the liquid composition to form a semiconducting layer.

Also disclosed is a semiconducting device comprising a substrate; a gate electrode; a gate dielectric layer; a source electrode; a drain electrode; and in contact with the source and drain electrodes and the gate dielectric layer, a semiconductor layer as described herein.

## DETAILED DESCRIPTION

Disclosed, in various embodiments, are semiconducting compositions. The compositions enable high mobility semiconducting materials to remain stable at room temperature while possessing characteristics suitable for processing, such as spin coating and ink jetting processing, including suitable viscosity. In some embodiments, when printed, the semiconducting composition may be referred to as an ink composition. In embodiments, semiconducting devices can be, for example, TFTs, diodes, photovoltaics, memory devices, and the like. In further embodiments, semiconducting devices are disclosed as TFTs comprising a substrate; a gate electrode; a gate dielectric layer; a source electrode; a drain electrode; and in contact with the source and drain electrodes and the gate dielectric layer, a semiconducting layer comprising the present semiconducting composition. Semiconductor devices herein can comprise any suitable or desired configuration. See, for example, U. S. Patent Publication 20080102559, for a description of a suitable electronic device configuration.

For example, semiconductor devices herein can comprise organic thin-film transistors ("OTFT"s) having a first bottom-gate OTFT configuration. The OTFT can comprise a substrate in contact with a gate electrode and a dielectric layer. The gate electrode can be disposed within or outside of the substrate. However, the dielectric layer separates the gate electrode from the source electrode, drain electrode, and the semiconducting layer. The source and drain electrodes contact the semiconducting layer. The semiconducting layer can be disposed over and between the source and drain electrodes. An optional interfacial layer can be located between the dielectric layer and the semiconducting layer.

Alternately, second bottom-gate OTFT configuration can be used comprising a substrate in contact with a gate electrode and a dielectric layer. The semiconducting layer is placed over or on top of the dielectric layer and separates it from the source and drain electrodes. An optional interfacial layer can be located between the dielectric layer and the semiconducting layer.

Another possible OTFT configuration comprises a third bottom-gate configuration comprising a substrate which also acts as the gate electrode and is in contact with a dielectric layer. The semiconducting layer is placed over or on top of the dielectric layer and separates the dielectric layer from the source and drain electrodes. An optional interfacial layer can be located between the dielectric layer and the semiconducting layer.

Further, a top-gate OTFT configuration can be used comprising a substrate in contact with the source and drain electrode and the semiconducting layer. The semiconducting layer runs over and between the source and drain electrodes. The dielectric layer is on top of the semiconducting layer. The gate electrode is on top of the dielectric layer and does not contact the semiconducting layer. An optional interfacial layer can be located between the dielectric layer and the semiconducting layer.

The semiconducting layer may be formed from a semiconducting composition as disclosed herein which is suitable for use in forming a thin film transistor, including a top-gate thin film transistor. The semiconducting composition comprises a semiconducting material, a liquid vehicle, a solubility promoter that enhances solubility of the semiconducting material, and optionally a crystallization inhibitor.

Any suitable semiconducting material can be used for the compositions herein. In embodiments, the semiconducting material is a p-type semiconducting material. In other embodiments, the semiconducting material is an n-type semiconducting material. In further embodiments, the semiconducting material is an ambipolar (both p-and n-types) semiconducting material. Exemplary semiconducting materials include thiophene-based polymer, triarylamine-based polymer, polyindolocarbazole, and the like. Thiophene-based polymer, includes for example, both regioregular and regiorandom poly(3-alkylthiophene)s, thiophene-based polymer comprising substituted and unsubstituted thienylene group, thiophene-based polymer comprising optionally substituted thieno[3,2-*b*]thiophene and/or optionally substituted thieno[2,3-*b*]thiophene group, thiophene-based polymer comprising benzothiophene, benzo[1,2-b:4,5-*b*']dithiophene, benzothieno[3,2-*b*]benzothiophene, dinaphtho-[2,3-*b*:2',3'-*f*]thieno[3,2-*b*]thiophene and thiophene-based polymer comprising non-thiophene based aromatic groups such as phenylene, fluorene, furan, and the like.

In embodiments, the semiconducting material comprises a compound of the formula

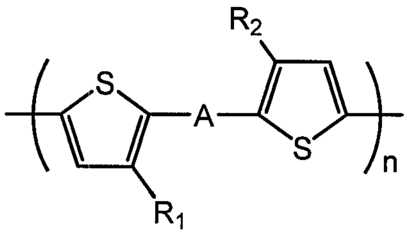

(I)

wherein A is a divalent linkage; $R_1$ and $R_2$ are each independently selected from hydrogen, alkyl, perhaloalkyl, alkoxyalkyl, siloxy-substituted alkyl, polyether, alkoxy, and halogen; and n is an integer from 2 to about 5,000. In some embodiments, $R_1$ and $R_2$ are independently alkyl containing from about 6 to about 30 carbon atoms, or from about 6 to about 20 carbon atoms.

Divalent linkage A can be selected from a compound of the formula

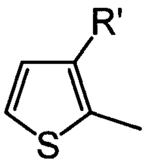 , 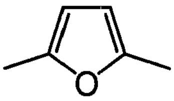 , 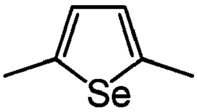 , 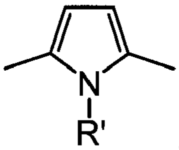 ,

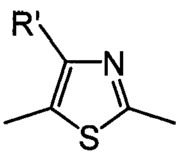 , 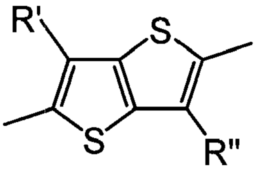 , 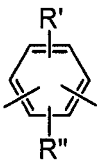 , 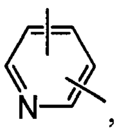 ,

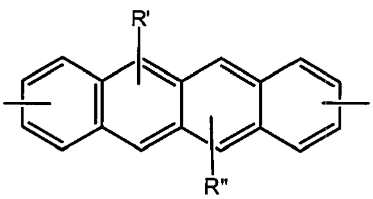 , 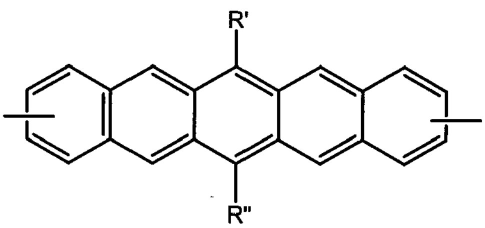 ,

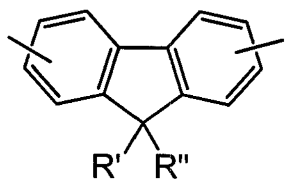

,

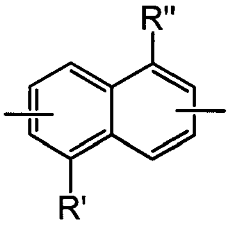

,

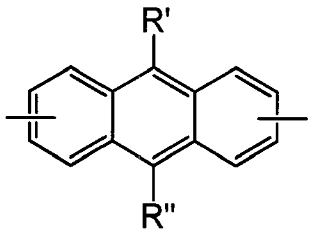

,

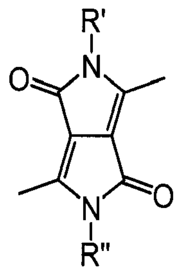

,

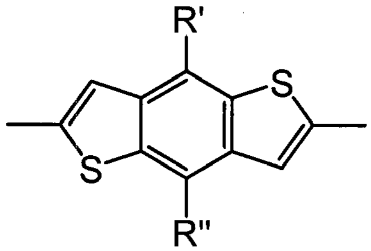

,

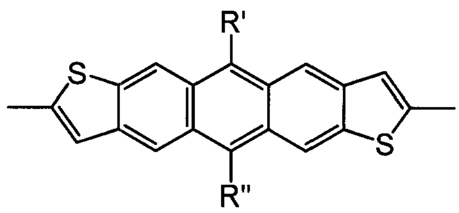

,

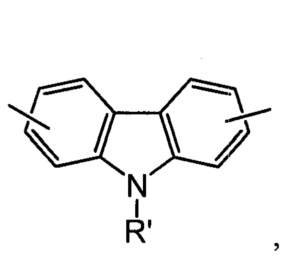

,

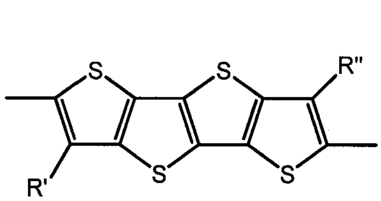

,

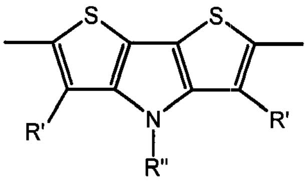
,
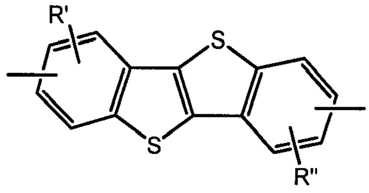
,

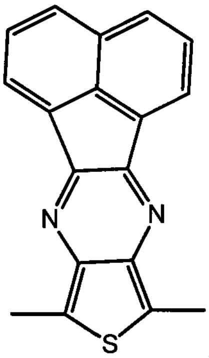
,
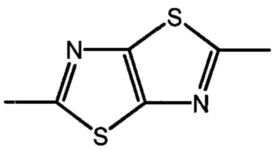
,
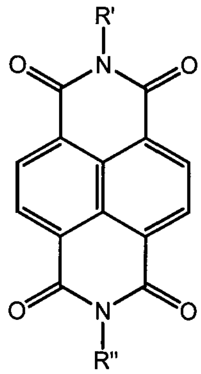

and combinations thereof, wherein R' and R" are independently selected from hydrogen, alkyl, substituted alkyl, aryl, substituted aryl, heteroaryl, halogen, such as fluorine, chlorine, and bromine, -CN, or $NO_2$. Substituents for alkyl and aryl can be any suitable substituent, for example -F, -Cl, $-OCH_3$, and the like. In further embodiments, R' and R" are alkyl or aryl containing from about 6 to about 30 carbon atoms, or from about 6 to about 20 carbon atoms.

In embodiments, the semiconducting material comprises a compound of the formula

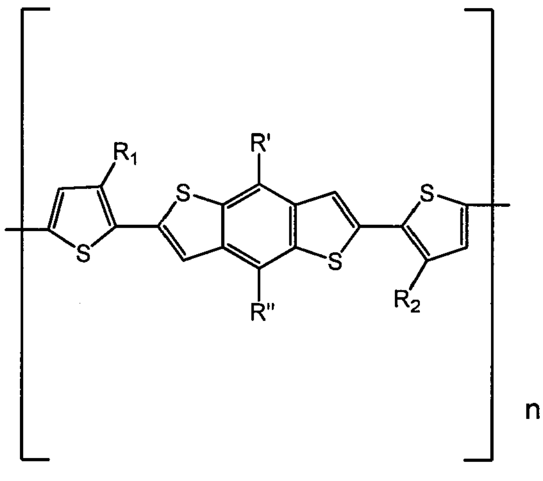
,

(II),

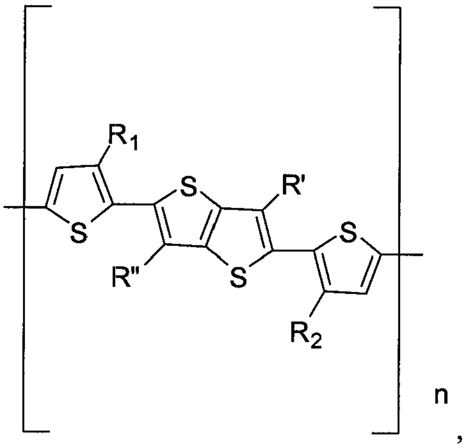

(III)

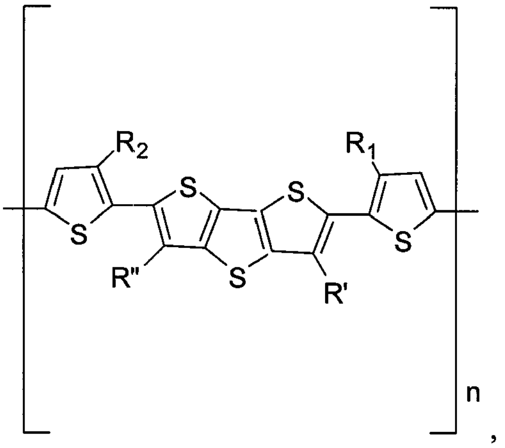

(IV)

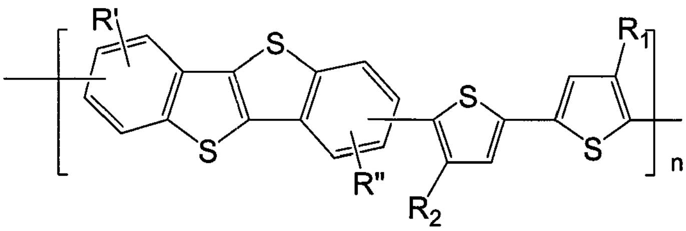

(V),

and

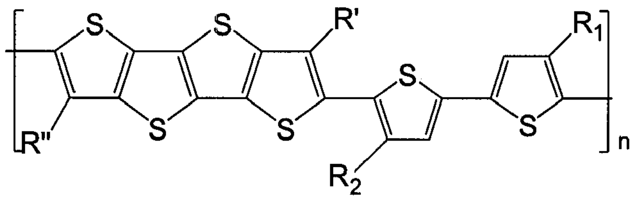

(VI)

wherein $R_1$, $R_2$, R', and R" are independently selected from i) hydrogen, ii) alkyl or substituted alkyl, iii) aryl or substituted aryl, iv) alkoxy or substituted alkoxy, v) a suitable hetero-containing group, vi) a halogen, or mixtures thereof; and n is an integer from about 2 to about 5,000. In embodiments, the semiconducting polymer can be a semiconducting polymer material as described in U. S. Patent Publications 20080102559 and 20080103286.

In embodiments, $R_1$, $R_2$, R', and R" are independently selected from at least one of hydrogen, a suitable hydrocarbon, a suitable hetero-containing group, and a halogen and where, for example, the hydrocarbon can be alkyl, alkoxy, aryl, substituted derivatives thereof, and the like, inclusive of side-chains containing, for example, from zero to about 35 carbon atoms, or from about 1 to about 30 carbon atoms, or from about 1 to about 20 carbon atoms, or from about 6 to about 18 carbon atoms; and n represents the number of repeating units such as a number of from about 2 to about 5,000, about 2 to about 2,500, about 2 to about 1,000, about 100 to about 800, or from about 2 to about 100.

In embodiments, $R_1$ and $R_2$ are the same or different and are each independently selected from a long carbon side-chain containing from about 6 to about 30 carbon atoms, or from about 6 to about 20 carbon atoms, and R' or R" are the same or different and are each independently selected from a substituent containing from 0 to about 5 carbon atoms; or $R_1$ and $R_2$ are each independently selected from a substituent containing from 0 to about 5 carbon atoms, and R' is a long carbon side-chain containing from 6 to about 30 carbon atoms. In embodiments, $R_1$ and $R_2$, R', and R" are independently alkyl with about 1 to about 35 carbon atoms of, for example, methyl, ethyl, propyl, butyl, pentyl, hexyl, heptyl, octyl, nonyl, decyl, undecyl, dodecyl, tridecyl, tetradecyl, pentadecyl, hexadecyl, heptadecyl or octadecyl; or arylalkyl with about 7 to about 42 carbon atoms of, for example, methylphenyl (tolyl), ethylphenyl, propylphenyl, butylphenyl, pentylphenyl, hexylphenyl, heptylphenyl, octylphenyl, nonylphenyl, decylphenyl, undecylphenyl, dodecylphenyl, tridecylphenyl, tetradecylphenyl, pentadecylphenyl, hexadecylphenyl, heptadecylphenyl, and octadecylphenyl. In another embodiment, $R_1$, $R_2$, R' and R" independently represent alkyl or substituted alkyl groups having from about 1 to about 35 carbon atoms.

In a specific embodiment, $R_1$, $R_2$, R', and R" are identical. In another specific embodiment, $R_1$, $R_2$, R' and R" are identical alkyl groups having from about 6 to about 18 carbon atoms.

In a specific embodiment, the semiconducting material is a compound of the formula

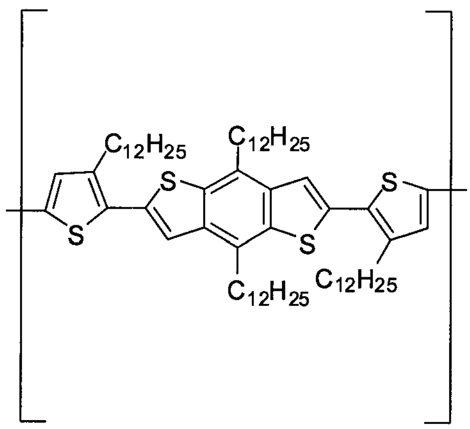

(1),

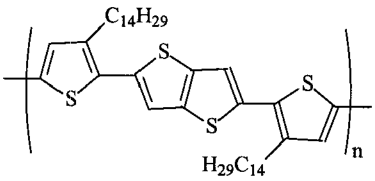

(2),

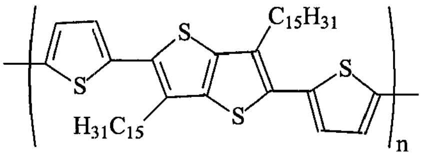

(3),

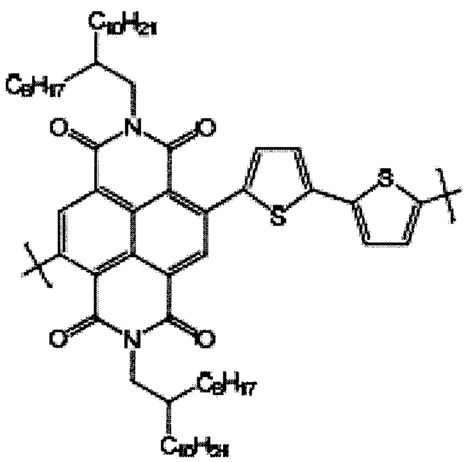

(4),

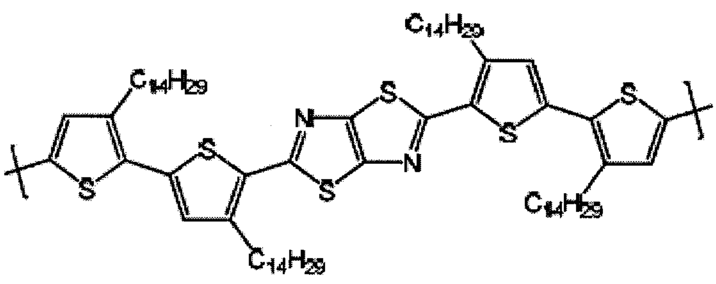

(5)

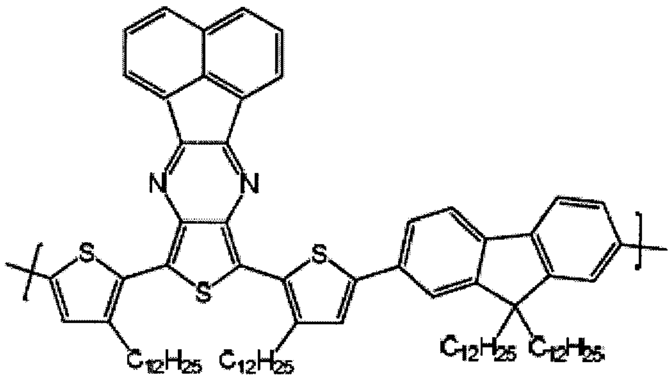

(6),

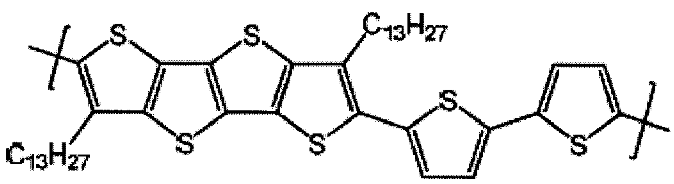

(7),

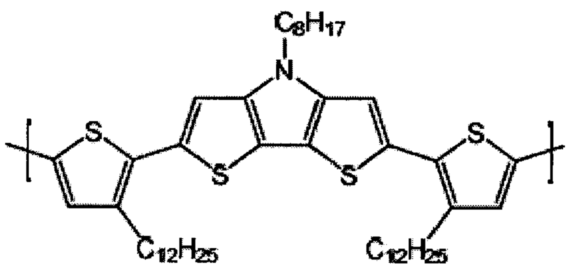

(8),

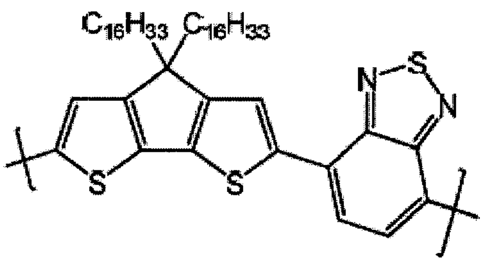

(9),

and

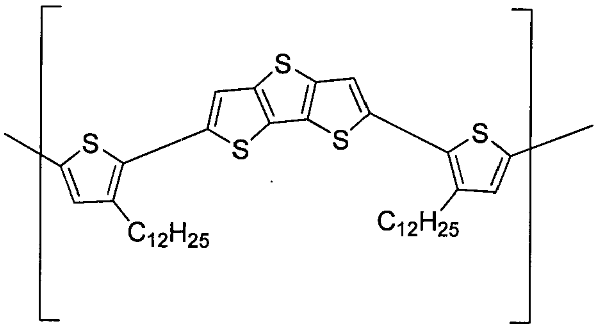

(10).

The number average molecular weight (Mn) of the polymers in embodiments can be, for example, from about 500 to about 400,000, including from about 1,000 to about 150,000, and the weight average molecular weight (Mw) thereof can be from about 600 to about 500,000, including from about 1,500 to about 200,000, both as measured by gel permeation chromatography using polystyrene standards.

In a specific embodiment, the semiconducting material is a compound of the formula (1). In another specific embodiment, the semiconducting material is a compound of the formula (2), (3), or (4).

The liquid vehicle can be any suitable or desired liquid vehicle. In embodiments, the liquid vehicle refers to a compound which is liquid at room temperature, normally, solvent. In embodiments, the liquid vehicle is an aromatic solvent. In further embodiments, the liquid vehicle is a halogenated aromatic solvent. Exemplary halogenated aromatic solvents include chlorobenzene, dichlorobenzene (1,2-dichlorobenzene, and 1,3-dichlorobenzene), trichlorobenzene, and chlorotoluene. In a specific embodiment, the liquid vehicle comprises 1,2-dichlorobenzene. In other embodiments, the liquid vehicle is a non-halogenated solvent. Exemplary non-halogenated aromatic solvents include toluene, xylene, mesitylene, trimethylbenezene, ethylbenzene, tetrahydronaphthalene, bicyclohexyl, and the like.

The solubility promoter can be any suitable or desired solubility promoter that enhances the solubility of the semiconducting material in the composition. The term "solubility promoter" refers to a compound or composition that can promote the solubility of the semiconductor material in the liquid vehicle. The solubility promoter can be any form, for example, a gel, a glass, a crystal, or a liquid. In further embodiments, the solubility promoter is a solid that is not flowable at room temperature, for example, a compound or composition that is a crystal or a glass at room temperature. It is also referred to as a "solid additive." In embodiments, the solubility promoter is a crystal. Further, in embodiments, the solubility promoter has a melting point of, for example, from about 35 to about 100 °C or from about 35 to about 80 °C.

A specific embodiment herein relates to the selection of solubility promoter. First, the solubility promoter is soluble in the liquid vehicle. For example, the solubility is from about 1 percent to about 80 percent by weight, including from about 5 percent to about 70 percent by weight, or from about 1 percent to about 20 percent by weight. Second, the solubility promoter has a solubility parameter similar to the semiconducting material. As to solubility parameters, for example, Hanson solubility parameters can be used. Both semiconducting material and solubility promoter are given three Hansen parameters, each measured in $MPa^{1/2}$, with $\delta_d$ being the energy from dispersion bonds between molecules, $\delta_p$ being the energy from polar bonds between molecules, and $\delta_h$ being the energy from hydrogen bonds between molecules. Interaction distance ($R_a$) between the solubility parameters of the semiconducting material and the solubility parameters of the solubility promoter can be calculated using the following formula:

$$R_a^2 = 4(\delta_{dsc}-\delta_{da})^2 + (\delta_{psc}-\delta_{pa})^2 + (\delta_{hsc}-\delta_{ha})^2$$

wherein $\delta_{dsc}$ is the energy from dispersion bonds between the semiconducting material molecules, $\delta_{da}$ is the energy from dispersion bonds between the solubility promoter molecules, $\delta_{psc}$ is the energy from polar bonds between the semiconducting material molecules, $\delta_{pa}$ is the energy from polar bonds between the solubility promoter molecules, $\delta_{hsc}$ is the energy from hydrogen bonds between the semiconducting material molecules, and $\delta_{ha}$ is the energy from hydrogen bonds between the solubility promoter molecules. When the solubility parameter of the solubility promoter is close to that of the semiconducting material, the value of $R_a$ is very small. In other words, in embodiments, a small $R_a$ is particularly selected. In embodiments, for example, the $R_a^2$ is less than about 10 MPa, less than about 8 MPa, less than about 5 MPa, or less than about 1 MPa. In further embodiments, the absolute value of $\delta_{dc}$-$\delta_{da}$ is less than 2.0

$MPa^{1/2}$ or less than about 1.0 $MPa^{1/2}$.

The semiconducting materials usually have a conjugated aromatic core (large $\delta_d$), but no or few polar groups (small $\delta_p$ and $\delta_h$). Therefore, in specific embodiments, it is selected that the solubility promoter has a $\delta_p + \delta_h$ less than about 8 $MPa^{1/2}$, or more specifically less than about 4 $MPa^{1/2}$, and a $\delta_d$ greater than about 18 $Mpa^{1/2}$, or more specifically greater than about 19 $MPa^{1/2}$.

In embodiments, the solubility promoter is a member selected from the group consisting of 3-chloro-5-fluorobenzonitrile, dichloronaphthalene, 1-chloro-4-(phenylethynyl) benzene, and 1,4-dichlorobenzene. In specific embodiments, the solubility promoter comprises 1,4-dichlorobenzene.

The optional crystallization inhibitor can be any desired or suitable crystallization inhibitor that works to inhibit or prevent altogether crystallization and precipitation of the solubility promoter out of the semiconducting ink composition solution. In embodiments, the optional crystallization inhibitor is present and is selected from the group consisting of chloronaphthalene, tetrahydronaphthalene, and 1,2,4-trichlorobenzene.

In a specific embodiment, the semiconducting material is a compound of the formula

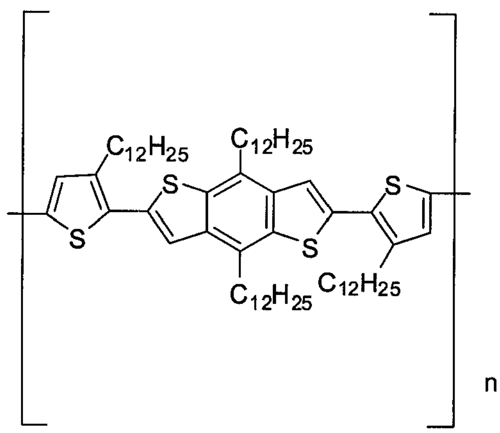

,

the liquid vehicle is 1,2-dichlorobenzene, the solubility promoter is 1,4-dichlorobenzene; and the optional crystallization inhibitor is present and is 1,2,4-trichlorobenzene.

The semiconducting ink composition can be prepared by any desired or suitable method, such as by combining the liquid vehicle, the solubility promoter, and the optional crystallization inhibitor and dissolving the semiconducting material therein.

In embodiments, the semiconducting material can be present in any form, for example, aggregates (for example, nano sized aggregates), dissolved molecules, or a combination thereof, in the liquid composition.

Without being bound by any theory, it is believed that the inclusion of solubility promoter improves the solubility and solution stability of the semiconducting material in the liquid vehicle. The similarly solubility parameters between the solubility promoter and the semiconducting material enable strong interaction between them at molecular level. Since the solubility promoter has a good solubility in the liquid vehicle, the solubility promoter/semiconducting polymer pair (or complex) can be dissolved and remain stable in the liquid vehicle.

Without being bound by any theory, it is believed that the inclusion of the crystallization inhibitor improves the stability of the ink composition by preventing the solubility promoter and/or the semiconducting material from precipitating out of solution at room temperature. In embodiments, the solubility promoter and semiconducting material remains substantially completely dissolved in the liquid vehicle at room temperature (that is, from about 20 °C to about 25 °C, or about 25 °C) for at least about 20 minutes, at least about 30 minutes, or at least about 1 day. In embodiments, the solubility promoter and semiconducting material remains substantially completely dissolved in the liquid vehicle at room temperature (referred to as "shelf life") for at least 25 minutes, at least 35 minutes or at least 1 hour. In embodiments, the solubility promoter and semiconducting material remains substantially completely dissolved in the liquid vehicle indefinitely. In embodiments, the shelf-life is significantly longer than the similar liquid composition wherein the solubility promoter is absent. In embodiments, the liquid composition has a shelf-life at least 50% longer than the similar liquid composition wherein the solubility promoter is absent. In further embodiments, the shelf-life is 2 times longer than the composition without the solubility promoter, or 10 times longer than the composition without the solubility promoter.

The semiconducting material, liquid vehicle, solubility promoter, and optional crystallization inhibitor can be present in any desired or effective amount. For example, the semiconducting material can be present in any desired or suitable amount, such as from about 0.1 to about 10, or from about 0.1 to about 2.0, or from about 0.1 to about 1.0 % by weight, based upon the total weight of the liquid composition. Similarly, the liquid vehicle can be present in any desired

or suitable amount, such as from about 20 to about 99, or from about 30 to about 95, or from about 40 to about 90 % by weight, based upon the total weight of the liquid composition. The solubility promoter can also be present in any desired or suitable amount, such as from about 0.1 to about 80, or from about 1 to about 70, or from about 5 to about 60 % by weight, based upon the total weight of the ink composition. Likewise, the optional crystallization inhibitor can be present in any desired or suitable amount, such as from about 0.1 to about 20, or from about 0.5 to about 10, or from about 1 to about 5 % by weight, based upon the total weight of the ink composition.

In certain embodiments, the semiconducting ink composition has a viscosity of from about 2 centipoise to about 40 centipoise, or from about 2 centipoise to 15 centipoise, or from about 4 to about 12 centipoise. This viscosity is suitable for inkjet printing.

The semiconducting ink formulation herein can be used to form the semiconducting layer in a thin film transistor, such as a bottom-gate bottom-contact transistor and a top-gate transistor. The semiconducting material may be deposited on a plastic substrate, such as polyethylene terephthalate, with medium surface energy, for example having an advancing water contact angle of about 60° to about 70°, or a hydrophobic gate dielectric material with a low surface energy, for example having an advancing water contact angle of about 90° to about 110°. The formulation is generally deposited onto a surface of the transistor and then dried to form the layer. Exemplary deposition methods include liquid deposition such as spin coating, dip coating, blade coating, rod coating, screen printing, stamping, ink jet printing, and the like, and other conventional processes known in the art. In embodiments, the deposition method is inkjet printing. The resulting semiconducting layer is from about 5 nm to about 1000 nm thick, especially from about 10 nm to about 100 nm thick.

The semiconductor compositions herein provide, in embodiments, advantages over previous materials. For example, semiconductor compositions herein provide extended stability at room temperature, which allows sufficient time for processing the semiconductor and preparing electronic devices therewith, such as by spin coating or inkjet printing layers of the compositions to prepare transistor devices. The present ink compositions can provide an increased shelf-life at room temperature of about 30 times greater than previously known ink compositions, thus enabling coating of homogeneous semiconductor layers for high-performance transistors.

The substrate may be composed of materials including but not limited to silicon, glass plate, plastic film or sheet. For structurally flexible devices, plastic substrate, such as for example polyester, polycarbonate, polyimide sheets and the like may be used. The thickness of the substrate may be any desired or suitable thickness, such as from about 10 micrometers to over 10 millimeters with an exemplary thickness being from about 50 micrometers to about 5 millimeters, especially for a flexible plastic substrate and from about 0.5 to about 10 millimeters for a rigid substrate such as glass or silicon.

The gate electrode is composed of an electrically conductive material. It can be a thin metal film, a conducting polymer film, a conducting film made from conducting ink or paste or the substrate itself, for example heavily doped silicon. Examples of gate electrode materials include but are not restricted to aluminum, gold, silver, chromium, indium tin oxide, conductive polymers such as polystyrene sulfonate-doped poly(3,4-ethylenedioxythiophene) (PSS-PEDOT), and conducting ink/paste comprised of carbon black/graphite or silver colloids. The gate electrode can be prepared by vacuum evaporation, sputtering of metals or conductive metal oxides, conventional lithography and etching, chemical vapor deposition, spin coating, casting or printing, or other deposition processes. The thickness of the gate electrode ranges from about 10 to about 500 nanometers for metal films and from about 0.5 to about 10 micrometers for conductive polymers.

The dielectric layer generally can be an inorganic material film, an organic polymer film, or an organic-inorganic composite film. Examples of inorganic materials suitable as the dielectric layer include silicon oxide, silicon nitride, aluminum oxide, barium titanate, barium zirconium titanate and the like. Examples of suitable organic polymers include polyesters, polycarbonates, poly(vinyl phenol), polyimides, polystyrene, polymethacrylates, polyacrylates, epoxy resin and the like. The thickness of the dielectric layer depends on the dielectric constant of the material used and can be, for example, from about 10 nanometers to about 500 nanometers. The dielectric layer may have a conductivity that is, for example, less than about $10^{-12}$ Siemens per centimeter (S/cm). The dielectric layer is formed using conventional processes known in the art, including those processes described in forming the gate electrode.

Typical materials suitable for use as source and drain electrodes include those of the gate electrode materials such as gold, silver, nickel, aluminum, platinum, conducting polymers, and conducting inks. In specific embodiments, the electrode materials provide low contact resistance to the semiconductor. Typical thicknesses are about, for example, from about 40 nanometers to about 1 micrometer with a more specific thickness being about 100 to about 400 nanometers. The OTFT devices of the present disclosure contain a semiconductor channel. The semiconductor channel width may be, for example, from about 5 micrometers to about 5 millimeters with a specific channel width being about 100 micrometers to about 1 millimeter. The semiconductor channel length may be, for example, from about 1 micrometer to about 1 millimeter with a more specific channel length being from about 5 micrometers to about 100 micrometers.

The source electrode is grounded and a bias voltage of, for example, about 0 volt to about 80 volts is applied to the drain electrode to collect the charge carriers transported across the semiconductor channel when a voltage of, for example, about +10 volts to about -80 volts is applied to the gate electrode. The electrodes may be formed or deposited

using conventional processes known in the art.

If desired, a barrier layer may also be deposited on top of the TFT to protect it from environmental conditions, such as light, oxygen and moisture, etc. which can degrade its electrical properties. Such barrier layers are known in the art and may simply consist of polymers.

The various components of the OTFT may be deposited upon the substrate in any order. The term "upon the substrate" should not be construed as requiring that each component directly contact the substrate. The term should be construed as describing the location of a component relative to the substrate. Generally, however, the gate electrode and the semiconducting layer should both be in contact with the dielectric layer. In addition, the source and drain electrodes should both be in contact with the semiconducting layer. The semiconducting polymer formed by the methods of the present disclosure may be deposited onto any appropriate component of an organic thin-film transistor to form a semiconducting layer of that transistor.

## EXAMPLES

The following Examples are being submitted to further define various species of the present disclosure. These Examples are intended to be illustrative only and are not intended to limit the scope of the present disclosure. Also, parts and percentages are by weight unless otherwise indicated.

### Comparative Example 1

5 milligrams of poly(4,8-didodecyl-2,6-bis(3-dodecylthiophen-2-yl)benzo[1,2-b:4,5-b']dithiophene (PBTBT-12), Formula 1, was dissolved in 1.0 grams 1,2-dichlorobenzene solvent by heating to form a clear, reddish solution. The solution was kept in an oven at 80 °C to isothermal for 10 minutes. The solution was removed from the oven and placed on the bench and allowed to cool at room temperature. The semiconducting polymer began to precipitate out at 8 minutes after the solution was removed from the oven. This 8 minute time includes cooling time from 80 °C to room temperature. The real shelf-life of the solution at room temperature was less than 2 to 3 minutes.

### Comparative Example 2

5 milligrams of PBTBT-12 was dissolved in 1.0 grams 1,2,4-dichlorobenzene solvent by heating to form a clear, reddish solution. The solution was kept in an oven at 80 °C to isothermal for 10 minutes. The solution was removed from the oven and placed on the bench and allowed to cool at room temperature. The semiconducting polymer began to precipitate out at 8 minutes after the solution was removed from the oven. This 8 minute time includes cooling time from 80 °C to room temperature. The real shelf-life of the solution at room temperature was less than 2 to 3 minutes.

### Example 1

5 milligrams of PBTBT-12 was dissolved in a 1.0 gram mixture of 1,4-dichlorobenzene and 1,2-dichlorobenzene containing 60 weight % 1,4-dichlorobenzene (solubility promoter) by heating to form a clear, reddish solution. The solution was kept in an oven at 80 °C to isothermal for 10 minutes. The solution was removed from the oven and placed on the bench and allowed to cool at room temperature. The semiconducting polymer was stable in the solution for 25 minutes, indicating an extended stability and shelf-life at room temperature. After 25 minutes, the semiconducting polymer began to precipitate out of the solution.

### Example 2

5 milligrams of PBTBT-12 was dissolved in a 1.0 gram mixture of 1,4-dichlorobenzene and 1,2-dichlorobenzene containing 66 weight % 1,4-dichlorobenzene by heating to form a clear, reddish solution. The solution was kept in an oven at 80 °C to isothermal for 10 minutes. The solution was removed from the oven and placed on the bench and allowed to cool at room temperature. The semiconducting polymer was stable in the solution for 35 minutes. After 35 minutes, the semiconducting polymer began to precipitate out of the solution.

### Example 3

5 milligrams of PBTBT-12 was dissolved in a 1.0 gram mixture of 1,4-dichlorobenzene, 1,2-dichlorobenzene, and 1,2,4-trichlorobenzene containing 66.7 weight % 1,4-dichlorobenzene and 6 weight % trichlorobenzene by heating to form a clear, reddish solution. The solution was kept in an oven at 80 °C to isothermal for 10 minutes. The solution was removed from the oven and placed on the bench and allowed to cool at room temperature. The semiconducting

polymer was stable in the solution for 60 minutes. After 60 minutes, the semiconducting polymer began to precipitate out of the solution.

1,4-dichlorobenzene is a solid at room temperature, and has a melting point of about 64 °C. By adding 1,4-dichlorobenzene to the semiconductor composition, the stability of the composition was extended significantly. While not wishing to be bound by theory, trichlorobenzene does not help to extend the shelf-life of the semiconductor composition, but rather helps to prevent the crystallization of the 1,4-dichlorobenzene. Therefore, the ternary system enables a higher loading of 1,4-dichlorobenzene, thus further extending the stability of the semiconducting polymer composition.

**Example 4**

Thin film transistors were fabricated with the semiconducting ink formulation of Example 3. An n-doped silicon wafer with a thermally grown silicon oxide layer of a thickness of about 200 nanometers was used. The wafer functioned as the substrate and the gate electrode. The silicon oxide layer acted as the gate dielectric layer and has a capacitance of about 15 nF/$cm^2$. The silicon wafer was first cleaned with isopropanol, argon plasma, and isopropanol, then air dried. The wafer was then immersed in a 0.1 M solution of dodecyltrichlorosilane in toluene for 20 minutes at 60 °C to modify the dielectric surface. The composition of Example 3 was spin coated on top of the modified silicon oxide surface, followed by drying in a 70 °C oven. Gold source and drain electrodes were vacuum evaporated on top of the semiconductor layer to complete the devices.
The transistors were characterized with a Keithley 4200 SCS under ambient conditions. They showed a field effect mobility of 0.2 to 0.24 cm2/V sec with a current on/off ratio over $10^6$ indicating the additive 1,4-dichlorobenzene had no adverse effect on device performance.

**Claims**

1. A liquid composition comprising:

a semiconducting material comprising a compound of the formula

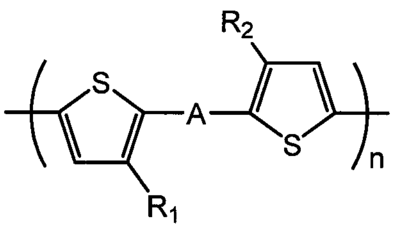

(I)

wherein A is a divalent linkage; $R_1$ and $R_2$ are each independently selected from hydrogen, alkyl, substituted alkyl, alkoxy, substituted alkoxy, a suitable hetero-containing group, a halogen, perhaloalkyl, alkoxyalkyl, siloxyl-substituted alkyl, polyether; and n is an integer from about 2 to about 5,000;
a liquid vehicle;
a solubility promoter that enhances solubility of the semiconducting material; and
an optional crystallization inhibitor.

2. The liquid composition of claim 1, wherein the divalent linkage is

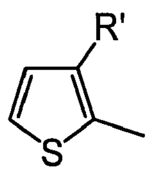 , 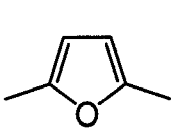 , 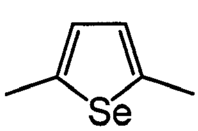 , 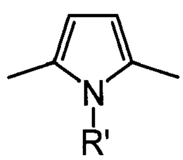 ,

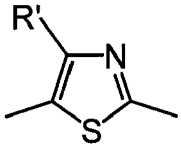,
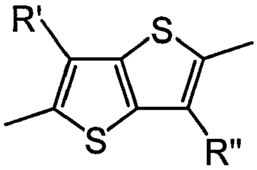,
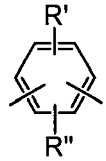,
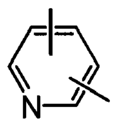,

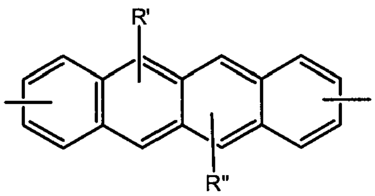,
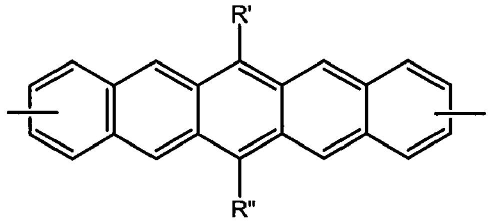,

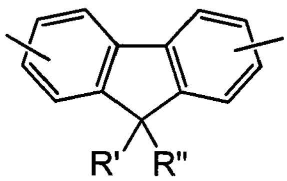,
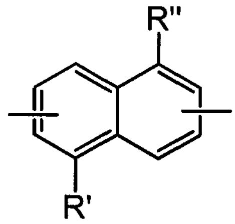,

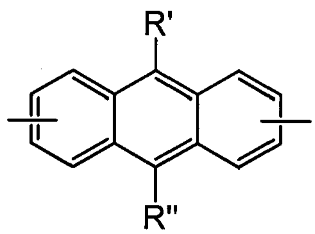,
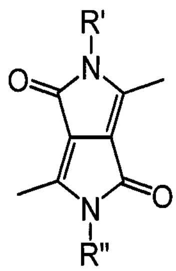,

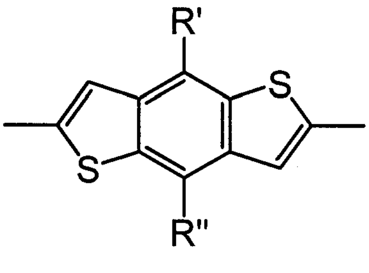,

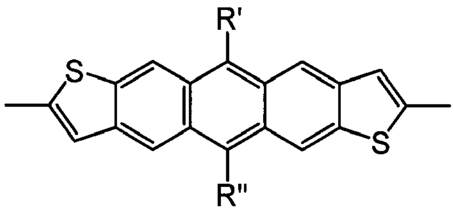

,

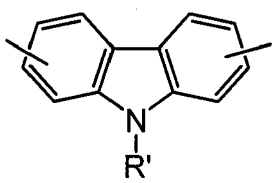

,

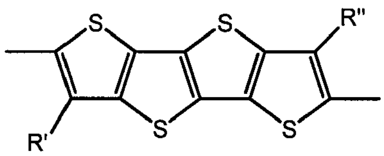

,

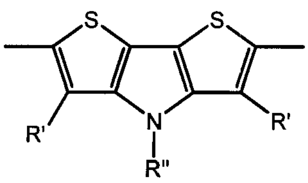

,

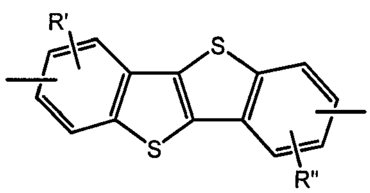

,

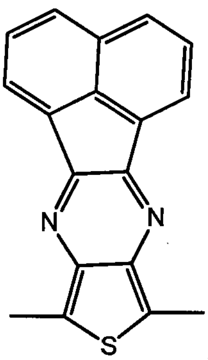

,

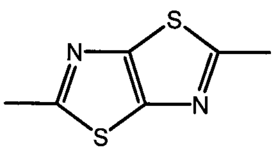

,

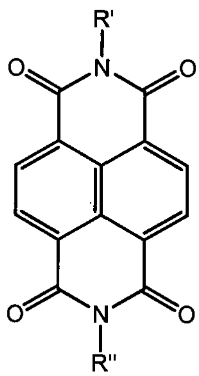

or a combination thereof; and
wherein each R' and R" is independently selected from hydrogen, alkyl, substituted alkyl, aryl, substituted aryl, heteroaryl, halogen,
-CN, or $NO_2$.

**3.** The liquid composition of claim 1, wherein the semiconducting material comprises a compound of the formula

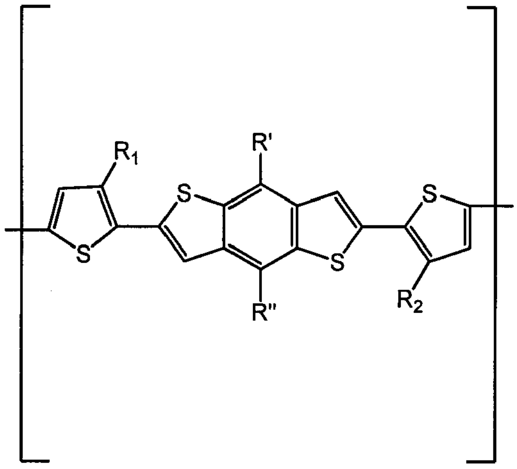

(II)

wherein $R_1$, $R_2$, R', and R" are each independently selected from hydrogen, alkyl, substituted alkyl, alkoxy, substituted alkoxy, a suitable hetero-containing group, a halogen, perhaloalkyl, alkoxyalkyl, siloxyl-substituted alkyl, polyether; and n is an integer from about 2 to about 5,000.

**4.** The liquid composition of claim 3, wherein $R_1$, $R_2$, R', and R" independently represent hydrogen, alkyl or substituted alkyl groups having from about 1 to about 35 carbon atoms, or wherein $R_1$, $R_2$, R', and R" are identical alkyl groups having from about 6 to about 18 carbon atoms.

**5.** The liquid composition of claim 1, wherein the semiconducting material is a compound of the formula

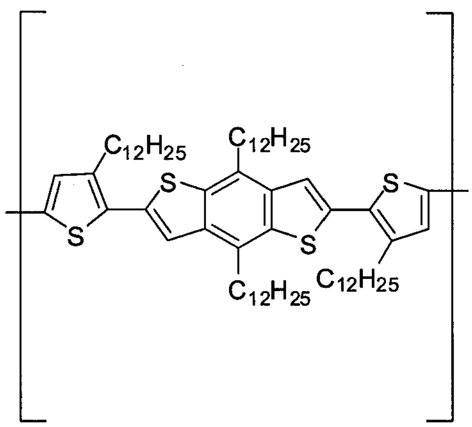

.

**6.** The liquid composition of claim 1, wherein the liquid vehicle is a halogenated aromatic solvent, or wherein the liquid vehicle is a solvent selected from the group consisting of chlorobenzene, 1,2-dichlorobenzene, 1,3-dichlorobenzene, dichlorobenzene, trichlorobenzene, and chlorotoluene, orwherein the liquid vehicle is a non-halogenated solvent.

**7.** The liquid composition of claim 1, wherein the solubility promoter has a Hanson solubility parameter similar to the semiconducting material; and
wherein the solubility promoter is capable of being dissolved in the liquid vehicle, preferably wherein the solubility promoter has a $\delta_d$ greater than about18 $MPa^{1/2}$, and wherein the sum of $\delta_p$ and $\delta_h$ is less than about 8 $MPa^{1/2}$.

**8.** The liquid composition of claim 1, wherein ($R_a$) is the interaction distance between the solubility parameters of the semiconducting material and the solubility parameters of the solubility promoter; and
wherein $R_a^2$ is less than about 8 MPa.

**9.** The liquid composition of claim 1, wherein $\delta_{dsc}$ is the energy from dispersion bonds between the semiconducting material molecules, $\delta_{da}$ is the energy from dispersion bonds between the solubility promoter molecules; and wherein the absolute value of $\delta_{dc}$-$\delta_{da}$ is less than about 2.0 $MPa^{1/2}$.

**10.** The liquid composition of claim 1, wherein the solubility promoter is 3-chloro-5-fluorobenzonitrile, dichloronaphthalene, 1-chloro-4-(phenylethynyl) benzene, or 1,4-dichlorobenzene, or
wherein the crystallization inhibitor is present and is selected from the group consisting of chloronaphthalene, tetrahydronaphthalene, or 1,2,4-trichlorobenzene.

**11.** The liquid composition of claim 1, wherein the semiconducting material is a compound of the formula

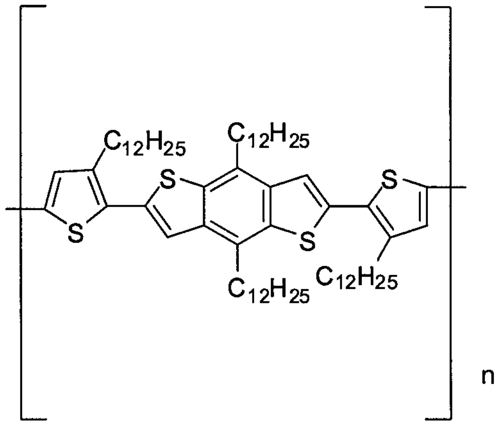

,

the liquid vehicle is 1,2-dichlorobenzene,
the solubility promoter is 1,4-dichlorobenzene; and
the optional crystallization inhibitor is 1,2,4-trichlorobenzene.

**12.** The liquid composition of claim 1, wherein the semiconducting material and the solubility promoter remain substantially completely dissolved in the liquid vehicle at room temperature for about at least 20 minutes.

**13.** The liquid composition of claim 1, wherein the liquid composition has a shelf-life that is at least two times longer than the shelf-life of the liquid composition that is free of the solubility promoter.

**14.** A method of forming a semiconducting layer of a thin film transistor comprising:

a) providing an liquid composition comprising:

a semiconducting material comprising a compound of the formula

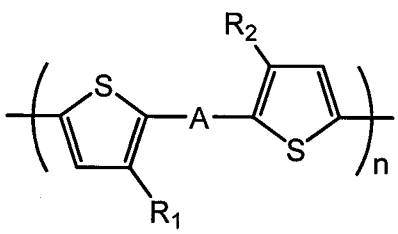

(I)

wherein A is a divalent linkage; $R_1$ and $R_2$ are each independently selected from hydrogen, alkyl, substituted alkyl, alkoxy, substituted alkoxy, a suitable hetero-containing group, a halogen, perhaloalkyl, alkoxyalkyl, siloxyl-substituted alkyl, polyether; and n is an integer from about 2 to about 5,000;

a liquid vehicle;
a solubility promoter that enhances solubility of the semiconducting material; and
an optional crystallization inhibitor;

b) applying the liquid composition over a substrate of the transistor; and
c) drying the liquid composition to form a semiconducting layer.

**15.** A semiconducting device comprising:

a substrate;
a gate electrode;
a gate dielectric layer;
a source electrode;
a drain electrode; and
in contact with the source and drain electrodes and the gate dielectric layer, a semiconductor layer comprising the liquid composition according to claim 1.

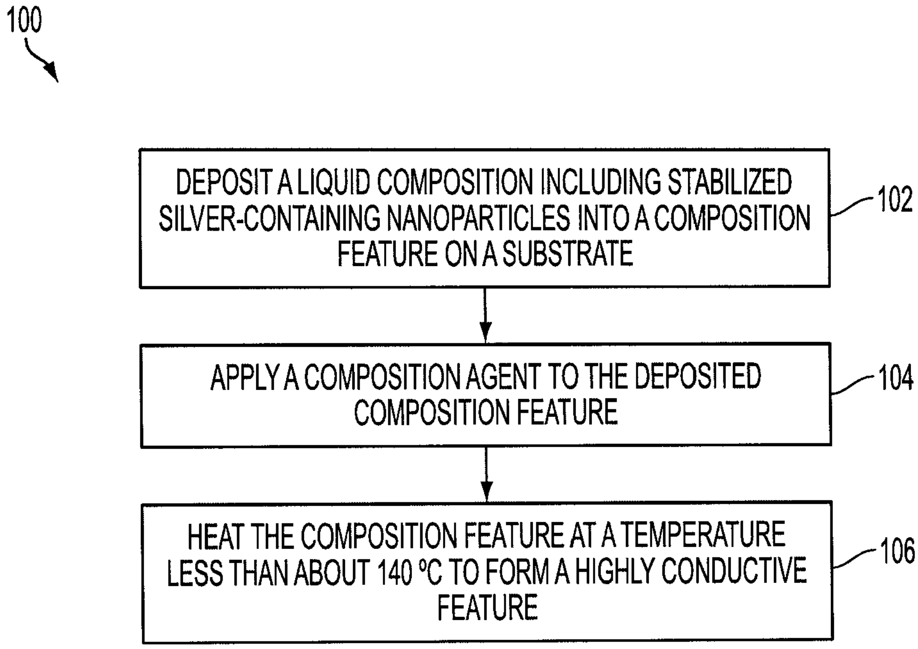
100
DEPOSIT A LIQUID COMPOSITION INCLUDING STABILIZED SILVER-CONTAINING NANOPARTICLES INTO A COMPOSITION FEATURE ON A SUBSTRATE
102
APPLY A COMPOSITION AGENT TO THE DEPOSITED COMPOSITION FEATURE
104
HEAT THE COMPOSITION FEATURE AT A TEMPERATURE LESS THAN ABOUT 140 °C TO FORM A HIGHLY CONDUCTIVE FEATURE
106

FIG. 1A

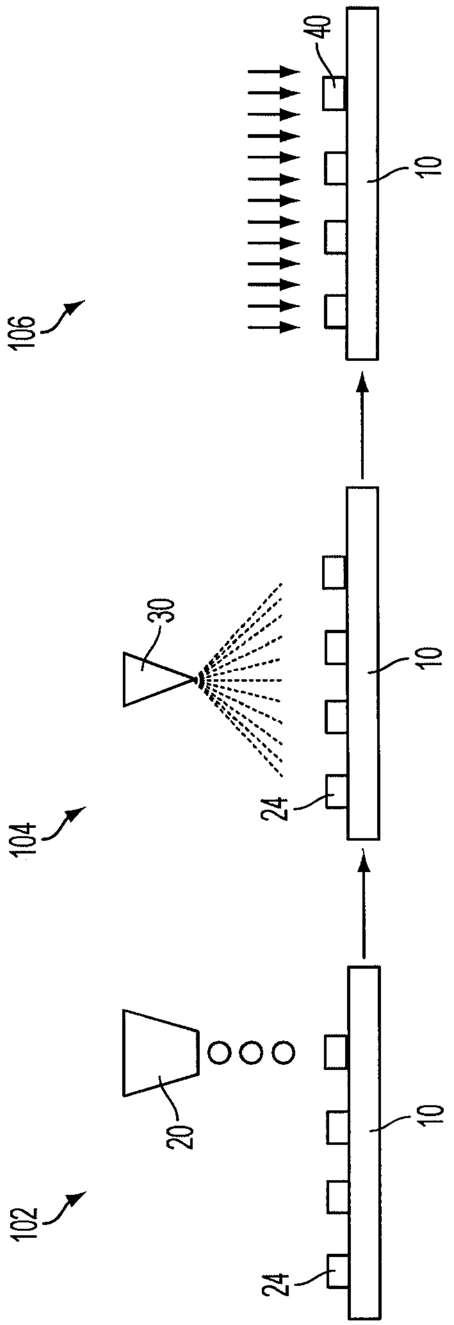


FIG. 1B

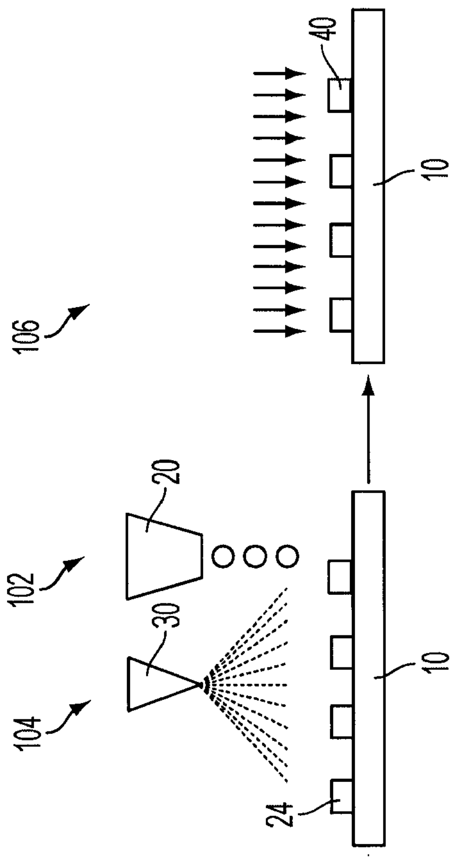


FIG. 1C

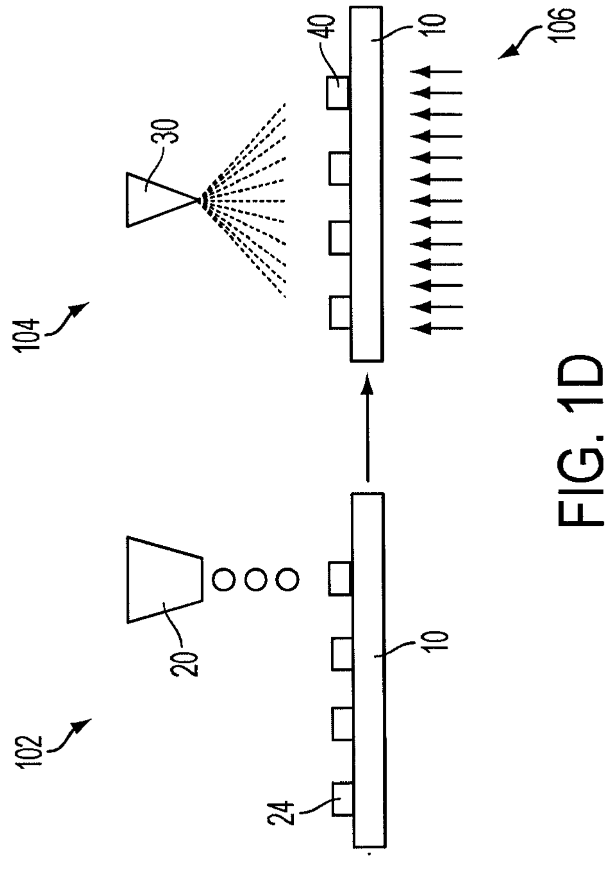


FIG. 1D

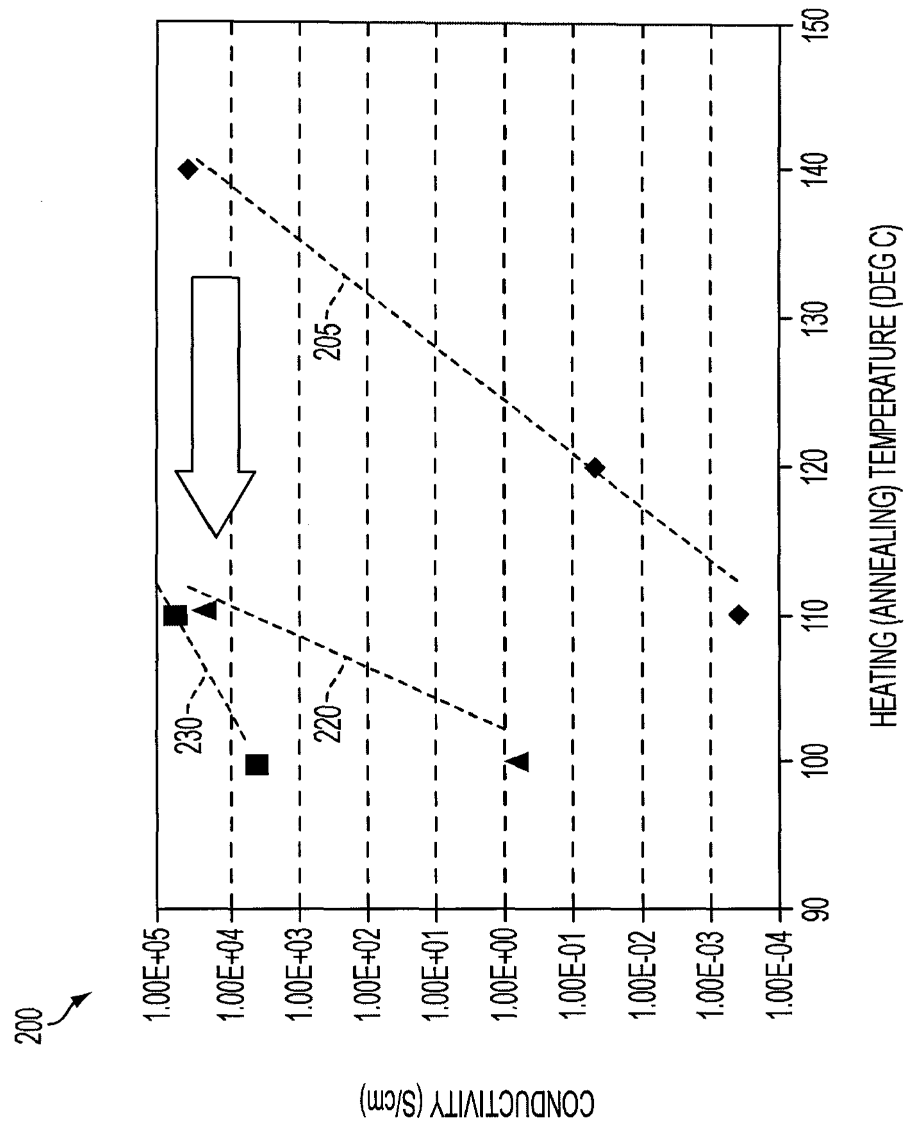
200
CONDUCTIVITY (S/cm)
1.00E+05
1.00E+04
1.00E+03
1.00E+02
1.00E+01
1.00E+00
1.00E-01
1.00E-02
1.00E-03
1.00E-04
90
100
110
120
130
140
150
HEATING (ANNEALING) TEMPERATURE (DEG C)
205
220
230

FIG. 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 20080102559 A
- US 20080103286 A